# EUROPEAN PATENT APPLICATION

(11) **EP 4 579 741 A1**
(43) Date of publication of application: **02.07.2025**
(21) Application number: 24220853.6
(22) Date of filing: 18.12.2024
(51) Int. Cl.: H01L 23/552, H01L 23/495, H01L 21/48, H01L 21/56

(54) **ELECTROMAGNETIC SHIELDING FOR LEADLESS SEMICONDUCTOR PACKAGE**

(30) Priority: 29.12.2023 US 202318400385
(71) Applicant: NXP USA, Inc., Austin, TX 78735 (US)
(72) Inventor: TANG, Jinbang, 5656AG Eindhoven (NL)
(74) Representative: Colaiuda, Antonella

(57) **Abstract**

Structures and methods for full-enclosure electromagnetic shielding of leadless semiconductor packages provide complete module-level electromagnetic shielding by combining plated shielding with proposed modified leadframe peripheral structure and ground pad grounding. A first cut into an overmolded leadless module exposes the peripheral ring of the leadframe; then, with controlled metal plating a full shielding enclosure is formed over the top of the package into contact with the exposed peripheral ring. The proposed approach provides complete electromagnetic shielding for the module with significantly improved electromagnetic shielding performance. The full enclosure shielding solution is especially important for high frequency and high-speed application and sensing products with high sensitivity to electromagnetic interference.

## Description

### TECHNICAL FIELD

The embodiments of the present disclosure relate to structures and methods for providing electromagnetic shielding of semiconductor packages and, more specifically, to systems and methods for manufacturing of quad flat no-lead (QFN) modules with full-enclosure electromagnetic shielding.

### BACKGROUND

Semiconductor devices are often found in a large spectrum of electronic products-from home monitoring devices like smoke detectors and alarms to automotive sensors, and so on. Many of these semiconductor devices may include sensitive systems and may be produced in high volumes to drive costs down. In example manufacturing processes, multiple semiconductor devices can be manufactured as a strip or a sheet and then "singulated" through cutting processes that separate each device from the others. The composite product of such processes, known as a "package," may comprise active and passive microelectronic components, integrated circuits, bonding wires, etc., mounted on a printed circuit board (PCB) or other substrate. The package itself electrically connects to other components in an electronic system. While some package designs provide for such connections using protruding wires or pins, the present disclosure pertains to "leadless" semiconductor packages, which have exposed conductive surfaces, called "pads" or as a misnomer "leads," that do not protrude from the package. For example, quad flat no-lead (QFN) designs have exposed pads on the bottom of the package and within its perimeter; the package is mounted on corresponding exposed pads on a PCB or other substrate.

Semiconductor devices for certain applications, such as high-sensitivity sensing, can be susceptible to interference from electromagnetic (EM) radiation and thus require EM shielding. A common solution for existing devices is to provide plates, casings, wires, or a combination thereof, made of high conductivity materials such as copper, aluminium, conductive polymers, metallized fabrics, etc. Properly positioned, these materials absorb or reflect unwanted EM energy, preventing the energy from reaching the sensitive parts of the device. Some of the more effective current solutions are designed to protect specifically selected components given a specific layout on a PCB; the reproducibility of these solutions is very low and the cost is very high. Additionally, these solutions may only provide partial shielding. Testing of current automotive safety sensors shows a maximum shielding of about 30 decibels of EM noise.

### SUMMARY

This disclosure provides package designs, systems, and methods for manufacturing leadless semiconductor devices in which the microelectronic components of the package are completely shielded from external electromagnetic energy. Effective and complete module-level EM shielding is realized by combining metallic plate shielding with a modified leadframe peripheral ring structure and signal lead structure and ground lead grounding, resulting in full-enclosure EM shielding. Beginning with an overmolded QFN (or other leadless) module, a first cut is made from the top of the module to expose the peripheral ring of the leadframe; then, controlled metal plating or other shielding is applied over the module, into contact with the exposed peripheral ring. A second cut is made from below the module to sever the signal lead from the peripheral ring. and combined cutting processes to achieve the full enclosure EM shielding for the lead frame modules. Individual devices may then be singulated from a manufacturing strip or sheet.

The proposed approach provides a complete EM shielding for the module with significantly improved EM shielding performance. The full enclosure shielding solution is especially important for high frequency and high-speed application and health related high-quality EMI sensitive products.

### BRIEF DESCRIPTION OF THE DRAWINGS

A more complete understanding of the subject matter may be derived by referring to the detailed description and claims when considered in conjunction with the following figures, wherein like reference numbers refer to similar elements throughout the figures.
FIG. 1A is a top perspective view of an example electromagnetic shielded leadless semiconductor package in accordance with this disclosure.
FIG. 1B is a cross-sectional top view of the semiconductor package of FIG. 1A taken along line A-A of FIG. 1A.
FIG. 1C is a cross-sectional side view of the microelectronics package of FIG. 1A taken along line B-B of FIG. 1B.
FIG. 2A is a cross-sectional top view of the semiconductor package of FIG. 1A during a first step of an example shielding process in accordance with this disclosure.
FIGS. 2B and 2C are partial cross-sectional side views of the semiconductor package of FIG. 1A during the step of FIG. 2A, taken along lines A-A and B-B of FIG. 2A, respectively.
FIG. 3A is a cross-sectional top view of the semiconductor package of FIG. 1A during a second step of the example shielding process.
FIGS. 3B and 3C are partial cross-sectional side views of the semiconductor package of FIG. 1A during the step of FIG. 3A, taken along lines A-A and B-B of FIG. 3A, respectively.
FIG. 4A is a cross-sectional top view of the semiconductor package of FIG. 1A during a third step of the example shielding process.
FIGS. 4B and 4C are partial cross-sectional side views of the semiconductor package of FIG. 1A during the step of FIG. 4A, taken along lines A-A and B-B of FIG. 4A, respectively.
FIG. 5A is a cross-sectional top view of the semiconductor package of FIG. 1A during a fourth step of the example shielding process.
FIGS. 5B and 5C are partial cross-sectional side views of the semiconductor package of FIG. 1A during the step of FIG. 5A, taken along lines A-A and B-B of FIG. 5A, respectively.

### DETAILED DESCRIPTION

It will be readily understood that the embodiments as generally described herein and illustrated in the appended figures could be arranged and designed in a wide variety of different configurations. Thus, the following more detailed description of various embodiments, as represented in the figures, is not intended to limit the scope of the present disclosure, but is merely representative of various embodiments. While the various aspects of the embodiments are presented in drawings, the drawings are not necessarily drawn to scale unless specifically indicated.

Embodiments of this disclosure may present in other specific forms without departing from its essential characteristics. The described embodiments are to be considered in all respects only as illustrative and not restrictive. The scope of the invention is, therefore, indicated by the appended claims rather than by this detailed description. All changes which come within the meaning and range of equivalency of the claims are to be embraced within their scope.

Reference throughout this specification to features, advantages, or similar language does not imply that all of the features and advantages that may be realized with the present invention should be or are in any single embodiment of the invention. Rather, language referring to the features and advantages is understood to mean that a specific feature, advantage, or characteristic described in connection with an embodiment is included in at least one embodiment of the present invention. Thus, discussions of the features and advantages, and similar language, throughout this specification may, but do not necessarily, refer to the same embodiment.

Furthermore, the described features, advantages, and characteristics of the invention may be combined in any suitable manner in one or more embodiments. One skilled in the relevant art will recognize, in light of the description herein, that the invention can be practiced without one or more of the specific features or advantages of a particular embodiment. In other instances, additional features and advantages may be recognized in certain embodiments that may not be present in all embodiments of the invention.

Reference throughout this specification to "one embodiment," "an embodiment," or similar language means that a particular feature, structure, or characteristic described in connection with the indicated embodiment is included in at least one embodiment of the present invention. Thus, the phrases "in one embodiment," "in an embodiment," and similar language throughout this specification may, but do not necessarily, all refer to the same embodiment.

For simplicity, the described features, advantages, and characteristics of the invention are described throughout this specification may be described as being implemented within an embedded device, semiconductor device or package, microelectronic device, etc., including one or more microprocessors, other processing units, programmable and/or non-programmable memory, and other integrated circuits as well as individual circuit components and other pieces of electronic equipment, but the present devices and methods may be implemented in other electronic devices for which the described package designs, systems, and methods of manufacture would be useful.

In the next generation of microelectronic semiconductor devices, and thereafter, it would be advantageous to fully shield EM-sensitive components, such as sensors, and reach a much higher level of EM noise attenuation. Put generally, the embodiments described herein provide for the production of leadless microelectronic semiconductor devices using package designs that fully shield the internal components of the semiconductor package from EM interference. Effective and complete module level EM shielding is realized by combining a plated shield with a modified leadframe peripheral ring structure and grounding arrangement for complete shielding. Given a complete, overmolded leadless semiconductor package, the present manufacturing processes may begin with a first cut into the package to expose one or more conductive contact surfaces of a peripheral ring of the leadframe. Then, a controlled metal plating step disposes metal top and side plates over the molding compound layer of the package and into contact with the exposed conductive surface(s) of the leadframe to fully enclose the module in EM shielding. Another cutting step from below the package severs a connection of each of the signal lead pads to the peripheral ring of the leadframe, leaving the ground (GND) lead pads in electrical contact with the peripheral ring. In some embodiments, another cutting step then singulates each shielded device from other shielded devices in a strip or sheet of devices. The proposed approach provides complete EM shielding for a leadless module with significantly improved EM shielding performance. The full enclosure shielding solution is especially important for high frequency and high-speed application and health related high-quality EM-sensitive products.

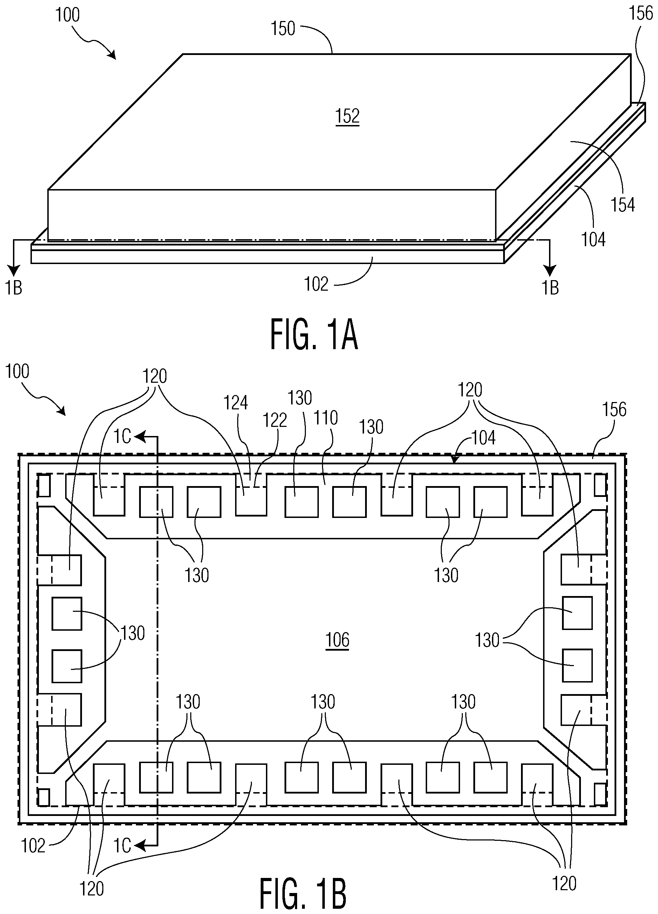

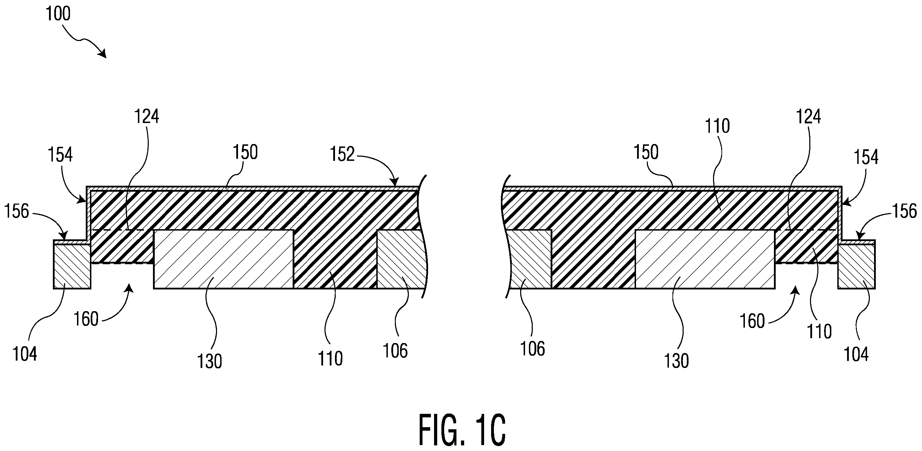

FIGS. 1A, 1B, and 1C illustrate an example microelectronic semiconductor device 100 manufactured to include full-enclosure EM shielding as described herein; the illustrations include the top perspective view of FIG. 1A illustrating the complete device 100, and simplified cross-sectional views of the device from the top (FIG. 1B) and side (FIG. 1C) to illustrate electrical connectivity of a leadframe 102 of the device 100 with ground pads 122 and signal pads 130 of the device 100 and with a shielding enclosure 150 of the device 100. The device 100 includes a microelectronics package comprising the leadframe 102, one or more electronic components attached to the leadframe 102, and a layer of molding compound 110 deposited, using any suitable overmolding or molding compound deposition technique, over the electronic components and onto/through the leadframe 102 to protect the components and the electrical connections. The leadframe 102 is a conductive metal layer that may serve as the base of a semiconductor device or may be mounted on a PCB or another substrate that serves as the base.

The leadframe 102 may be a metal sheet or film etched into segments to facilitate control of the signal paths between various components electrically connected to the leadframe 102 and to input/output leads (e.g., signal pads 130) of the device 100. In embodiments, the leadframe 102 may comprise a peripheral ring 104 extending around and defining the perimeter of the device 100, and a ground flag portion 106 that is electrically connected to the peripheral ring 104 and that provides a ground plane for the device 100 and also may serve as or support a die pad to which electronic components are bonded. The device further includes a plurality of ground leads 120 each in electrical contact with the peripheral ring 104 and each comprising of the ground pads 122 of the device. In some embodiments, a connecting portion 124 of each ground lead 120 connects the corresponding ground pad 122 to the peripheral ring 104. The device further includes a plurality of conductive lead pads 130 electrically isolated from the peripheral ring 104. The ground pads 122 and lead pads 130 may be exposed through the bottom of the device 100 to receive electrical connections of other devices to the device 100.

The electronic components that may be electrically connected to the leadframe 102 and to the signal pads 130 before the molding process include microcontrollers, sensors, wireless transmitters/receivers, application-specific and other integrated circuits, semiconductor devices, basic components such as capacitors and resistors, and the like. The components can be directly connected (e.g., via soldering), wire-bonded, etc., to bond the components in electrical contact with the leadframe 102 and/or the signal pads 130. Once the components are attached, an insulating, protective molding compound 110, which may be any suitable material used in semiconductor molding processes such as transfer, compression, or injection molding, flow deposition, etc., is deposited over the components and the leadframe 102 to produce a semiconductor package comprising the leadframe 102, ground leads 120, signal pads 130, all attached electronic components, and the molding compound 110. The device 100 may further include one or more voids 160 formed into the semiconductor package during manufacture to disconnect the signal pads 130 from the leadframe 102, as described further below.

The present disclosure provides advantages over known approaches to EM shielding of a semiconductor package such as that of the device 100. The shielding enclosure 150 is designed to fully encapsulate the semiconductor package in EM shielding. The enclosure 150 comprises a top plate 152, a plurality of side plates 154 attached to or integral with the top plate 152 and with adjacent side plates 154, and a shoulder portion 156 attached to or integral with the side plates 154 and electrically attached or connected to the peripheral ring 104 of the leadframe 102. Each of the top plate 152, side plates 154, and shoulder portion 156 are made of a suitable metal for plated EM shielding, such as steel, copper, nickel, aluminum, and suitable alloys thereof; each of the top plate 102, the side plates 154, and the shoulder portion 156 may be the same or different metals. The enclosure 150 may be deposited or formed onto the semiconductor package using any suitable plating or deposition technique, provided a complete enclosure 150 is formed, without seams or voids and with a complete connection between the enclosure 150 and the leadframe 102 entirely along the peripheral ring 104 (i.e., the perimeter of the device 100). For example, all of the top plate 152, side plates 154, and shoulder portion 156 may be formed in a single deposition process that creates all of the parts 152, 154, 156 of the enclosure 150 integrally with each other.

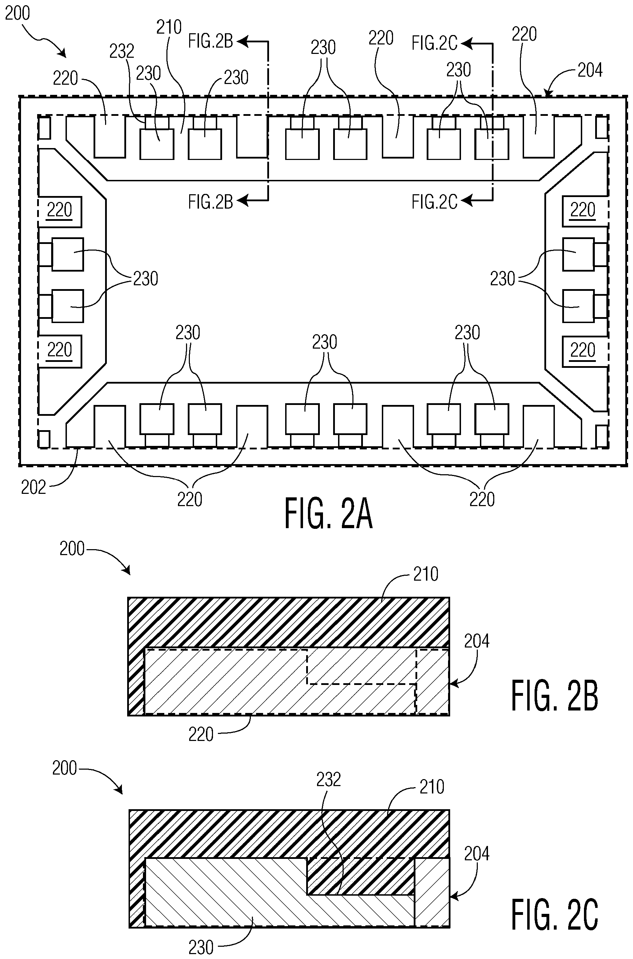

An example method of manufacturing a full-enclosure EM shielded leadless semiconductor device, such as the device 100 of FIGS. 1A-C, will now be described with reference to the remaining Figures. In FIGS. 2A, 2B, 2C, an example prefabricated semiconductor package 200 is provided for the first step of the example method. The package 200 may include a leadframe 202 with peripheral ring 204, a plurality of ground leads 220, and a plurality of signal pads 230, all disposed under a layer of molding compound 210, as described above. Additionally, at this point of manufacture, the signal pads 230 of the package 200 may be electrically connected to the peripheral ring 204 of the leadframe 202 by a conductive connecting portion 232. As shown, the connecting portion 232 is substantially flush with the signal pad 230 along a bottom surface of both, and the connecting portion 232 is less thick than the signal pad 230 and the ground lead 220. For example, the connecting portion 232 may be approximately half the thickness of the signal pad 230. While at this point the ground leads 220 and the signal pads 230 are attached to the leadframe 202, the ground leads 220 and signal pads 230 are separated from each other within the peripheral ring 204 by physical space filled with the molding compound 210.

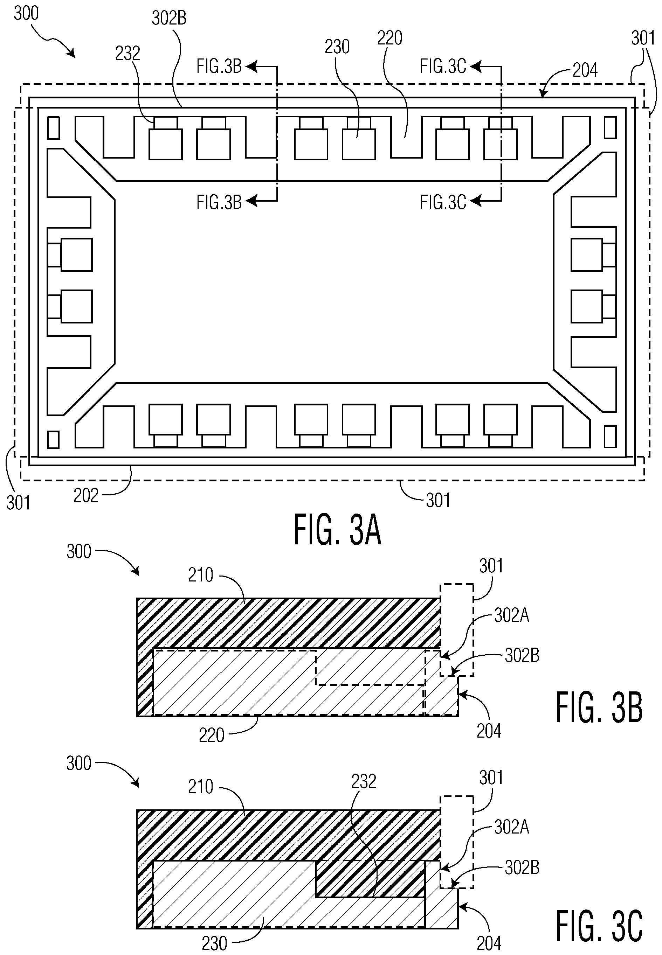

The semiconductor package 200 is modified by a step of the manufacturing process, as shown in FIGS. 3A, 3B, and 3C, to produce a modified semiconductor package 300. In particular, a cut 301 is made into all four sides around the periphery of the semiconductor package 200 of FIGS. 2A-C to produce the semiconductor package 300 of FIGS. 3A-C. The cut 301 may be made using any suitable mechanical or laser cutting method, and may extend through the layer of molding compound 210 and partially or substantially into the peripheral ring 204 of the leadframe 202. The cut 301 exposes the peripheral ring 202, creating one or more contact surfaces of the peripheral ring 202 extending around the perimeter of the package 300. For example, as illustrated, the cut 301 forms a notch in the peripheral ring 202, the notch defined by a vertical contact surface 302A corresponding to the outer vertical edge of the cut 301 and a horizontal contact surface 302B corresponding to the vertically deepest edge of the cut 301. By "partially or substantially," it is meant that the cut extends into the peripheral ring 204 far enough to expose sufficient surface area within the peripheral ring 204 so that the metal plating subsequently applied will form a substantial mechanical and chemical bond with the peripheral ring 204 at the exposed contact surface(s) 302A, 302B, when applied as described below. Both the horizontal and the vertical depths of the cut 301 into the peripheral ring 204 can be, for example, to a depth of between 5 micrometers to 15 micrometers into the peripheral ring 204, which may have a thickness of between 100 and 300 micrometers.

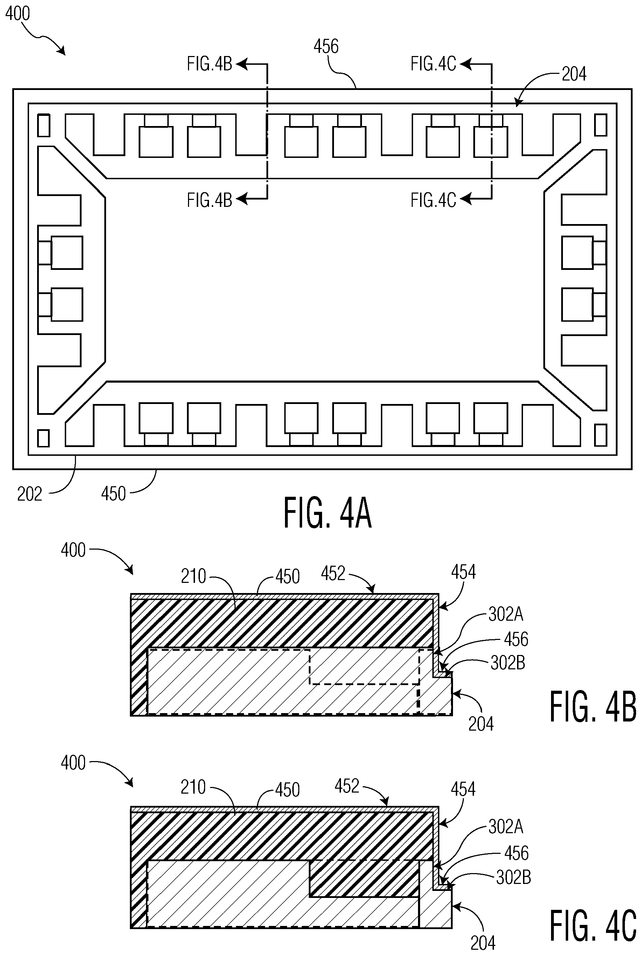

The semiconductor package 300 is modified by a step of the manufacturing process, as shown in FIGS. 4A, 4B, and 4C, to produce another modified semiconductor package 400. In particular, the step depicted in FIGS. 4A-C is the electromagnetic shielding, by deposition of metal plating, metal material dispensing, or another suitable shielding method, of the semiconductor package of FIGS. 3A-C to produce a shielding enclosure 450 of the semiconductor package 400 of FIGS. 4A-C. In some embodiments, deposition of a layer of metal that is suitable for EM shielding, such as a copper-nickel or copper-aluminum alloy, forms the shielding enclosure 450 as an arrangement of integrated metal plates, including a top plate 452 on top of the package 400, side plates 454 extending from the top plate 452 down all four sides of the package 400 into contact with the leadframe 202, and a connecting portion 456 extending from the side plates 454 and disposed in contact with the peripheral ring 204 of the leadframe 202. In particular, the connecting portion 456 may be in contact with a horizontal surface of the peripheral ring 204, such as the contact surface 302B exposed by the cut 301 of the previous step described above with respect to FIGS. 3A-C. In some embodiments, further encapsulating contact is made between the side plates 454 and the peripheral ring 204, such as at the contact surface 302A also exposed by the cut 301 described above. The metal of the shielding enclosure 450 may be selected so that as it cures/hardens, the parts of the shielding enclosure 450 in contact with the surface(s) of the leadframe 202 bond to said surface(s), creating a permanent electrical and mechanical connection between the shielding enclosure 450 and the leadframe 202 entirely around the peripheral ring 204 thereof.

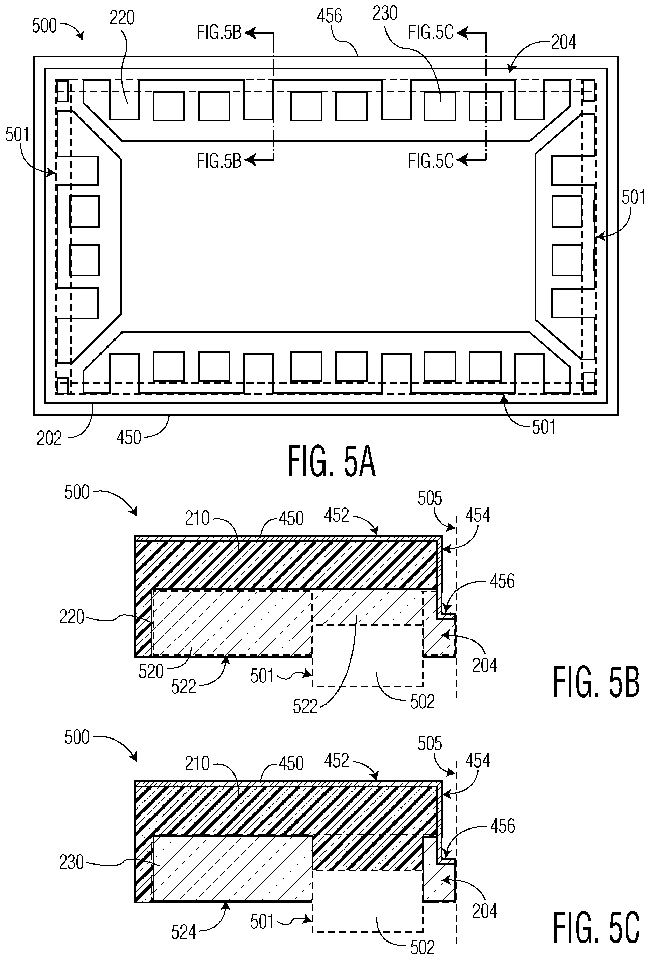

In some embodiments, the fully EM shielded semiconductor package 400 is further modified by one or more additional steps of the manufacturing process, as shown in FIGS. 5A, 5B, and 5C, to produce a completed semiconductor device 500. In particular, when the previous steps described above are completed, the signal pads 230 remain physically and electrically connected to the leadframe 202 (i.e., by the connecting portions 232 of FIGS. 2A-C). This physical and electrical connection is severed by making a cut 501 from beneath the semiconductor package, inside and along all four sides of the peripheral ring 204 of the leadframe 202; the cut 501 is sufficiently deep to cut through all connecting portions 232, but is substantially less deep than the leadframe 202 is thick. For example, the connecting portions 232 may be about half the thickness of the leadframe 202, and consequently the cut 501 need be only half as deep as the leadframe 202 is thick. Typically, the thickness of the leadframe 202 is from 100 micrometers to 300 micrometers. The cut 501 may further have a sufficient width to completely eliminate the connecting portions 232, as illustrated.

In some embodiments, only the connecting portions 232 may be cut; for manufacturing efficiency, the cut 501 may extend along substantially the entire length of each edge of the peripheral ring 204, leaving a cavity 502 as illustrated. Correspondingly, the cut 501 is also disposed through each of the ground leads 220, but the ground leads 220, having the same or approximately the same thickness as the leadframe 202, are not severed; a connecting portion 522 of the ground lead 220 remains above the cavity 502, connecting the ground pad 520 to the peripheral ring 204. In any embodiment, the cut 501 physically and electrically separates the signal pads 230 from the peripheral ring 204 of the leadframe 202 and from the ground leads 220 as well. In some embodiments, the step of performing the cut 501 may be performed before the shielding enclosure 450 is applied. Once the cut 501 is made and the shielding enclosure 450 is hardened or cured, for devices 500 manufactured as a strip or sheet, (an) additional cut(s) 505 may be made to singulate the device 500 from the strip or sheet.

The present disclosure describes various implementations of a full-enclosure EM shielded microelectronic semiconductor device and methods of manufacture that completely shield sensitive components from EM noise. In some aspects, the disclosure provides a method of manufacturing a semiconductor device, the method including providing a microelectronics package that includes: a leadframe including a peripheral ring that defines a perimeter of the microelectronics package; a plurality of ground leads attached to or integral with the leadframe, each of the plurality of ground leads including a ground pad that is exposed through a bottom of the microelectronics package; a plurality of signal pads exposed through the bottom of the microelectronics package; one or more microelectronic components each affixed to one or both of the leadframe and one or more of the plurality of signal pads; and, a layer of molding compound disposed over the leadframe, the plurality of ground leads, the plurality of signal pads, and the one or more microelectronic components. The method further includes the steps of: making a first cut into the microelectronics package at the perimeter, the first cut extending from a top of the microelectronics package into the peripheral ring of the leadframe to expose one or more contact surfaces of the peripheral ring; and, forming a shielding enclosure that completely covers the top of the microelectronics package and a plurality of sides of the microelectronics package formed by the first cut, and that contacts the peripheral ring at the one or more contact surfaces, the shielding enclosure comprising an electromagnetic shielding material, and the shielding enclosure maintaining contact with the peripheral ring entirely around the microelectronics package.

The layer of molding compound may extend to the perimeter of the microelectronics package, and making the first cut may include cutting vertically through the layer of molding compound to a first depth within the peripheral ring to form the plurality of sides including a vertical contact surface of the one more contact surfaces. Making the first cut may include forming a notch in the peripheral ring extending inward from the perimeter, the one or more contact surfaces comprising a vertical surface and a horizontal surface defined by the notch. Forming the shielding enclosure may include the steps of: forming a top plate of the shielding enclosure on the top of the microelectronics package; forming a plurality of side plates of the shielding enclosure each on a corresponding side of the of the plurality of sides, the plurality of side plates each being integral with the top plate and with adjacent side plates and each contacting the vertical surface of the notch; and, forming a connecting portion of the shielding enclosure on the horizontal surface of the notch, the connecting portion being integral with the plurality of side plates and extending around the perimeter.

Forming the shielding enclosure may include depositing the electromagnetic shielding material onto the microelectronics package with a metal plating process. The plurality of signal pads may each be electrically connected to the peripheral ring of the leadframe, the method further including severing the electrical connection between the peripheral ring and the plurality of signal pads. The microelectronics package may further include a plurality of conductive connecting portions each connecting a corresponding signal pad of the plurality of signal pads to the peripheral ring of the leadframe; severing the electrical connection may include making a second cut into the bottom of the microelectronics package and through the plurality of connecting portions. The microelectronics package may further include a plurality of conductive connecting portions each attached to or integral with a corresponding one of the plurality of signal pads, attached to the peripheral ring of the leadframe, disposed approximate the bottom of the microelectronics package, and having a thickness that is less than a thickness of the leadframe; the plurality of ground leads each has the thickness of the leadframe, and the method may further include making a second cut into the bottom of the microelectronics package inward of the peripheral ring and through the plurality of connecting portions and the plurality of ground leads, the second cut having a depth at least equal to the thickness of the plurality of connecting portions and less than the thickness of the plurality of ground leads.

In another aspect, the present disclosure provides an electromagnetically shielded microelectronic semiconductor device including a microelectronics package including: a leadframe including a peripheral ring that defines a perimeter of the semiconductor device; a plurality of ground pads and a plurality of signal pads exposed through the bottom of the microelectronics package, the ground pads in electrical communication with the leadframe; one or more microelectronic components each affixed to one or both of the leadframe and one or more of the plurality of signal pads; and, a layer of molding compound disposed over the leadframe, the plurality of ground pads, the plurality of signal pads, and the one or more microelectronic components, a top surface of the layer defining a top of the microelectronics package. The semiconductor device further includes a shielding enclosure that completely covers the top of the microelectronics package and a plurality of sides of the microelectronics package and that contacts the peripheral ring entirely around the microelectronics package along or within the perimeter, the shielding enclosure including an electromagnetic shielding material and cooperating with the leadframe to provide full-enclosure electromagnetic shielding to the one or more microelectronic components.

The peripheral ring may include a horizontal contact surface extending inward along the perimeter, the shielding enclosure contacting the horizontal contact surface. The peripheral ring may include a notch including the horizontal contact surface and a vertical contact surface extending from a top of the peripheral ring downward to connect with the horizontal contact surface, the shielding enclosure further contacting the vertical contact surface. The vertical contact surface of the peripheral ring and a vertical surface of the layer of molding compound may together define the plurality of sides of the microelectronics package, the plurality of sides being disposed inward from the perimeter. The shielding enclosure may include: a top portion disposed on the top of the microelectronics package; a connecting portion disposed on the horizontal contact surface; and, a plurality of side portions each disposed on a corresponding side of the plurality of sides and each attached to or integral with the top portion, the connecting portion, and adjacent side portions. The shielding enclosure may include metal plating. The peripheral ring of the leadframe may have a thickness measured from the bottom of the microelectronics package. The microelectronics package may further include a plurality of ground leads attached to or integral with the peripheral ring and having the thickness of the peripheral ring, each of the plurality of ground leads including a corresponding one of the plurality of ground pads; and, the semiconductor device may further include a cavity disposed in the bottom of the microelectronics package adjacent to the peripheral ring, the cavity having a depth that is less than the thickness of the peripheral ring, the plurality of signal pads being electrically isolated from the peripheral ring by the cavity.

In yet another aspect, the present disclosure provides a method of manufacturing a packaged semiconductor device, the method including providing a quad flat no-lead microelectronics package including: a leadframe including a peripheral ring that defines a perimeter of the microelectronics package; a plurality of ground pads and a plurality of signal pads exposed through the bottom of the microelectronics package, the ground pads in electrical communication with the leadframe; one or more microelectronic components each affixed to one or both of the leadframe and one or more of the plurality of signal pads; and, a layer of molding compound disposed over the leadframe, the plurality of ground pads, the plurality of signal pads, and the one or more microelectronic components. The method further includes the steps of: exposing one or more contact surfaces of the peripheral ring entirely around a perimeter of the microelectronics package; and, forming a shielding enclosure that completely covers the layer of molding compound and contacts the peripheral ring at the one or more contact surfaces, the shielding enclosure comprised of an electromagnetic shielding material, and the shielding enclosure maintaining contact with the peripheral ring entirely around the microelectronics package.

The layer of molding compound may extend to the perimeter of the microelectronics package, and exposing the one or more contact surfaces may include making a first cut into the microelectronics package at the perimeter, the first cut extending from a top of the microelectronics package through the layer of molding compound to expose a horizontal surface of the one or more contact surfaces of the peripheral ring. Exposing the one or more contact surfaces may further include making a first cut into the peripheral ring to form a notch including a horizontal surface and a vertical surface of the one or more contact surfaces of the peripheral ring. Forming the shielding enclosure may include the steps of: forming a top portion of the shielding enclosure on a top surface of the layer of molding compound; forming a connecting portion of the shielding enclosure on the horizontal surface of the notch, the connecting portion extending around the microelectronics package; and, forming a plurality of side portions of the shielding enclosure each extending vertically between the top portion and the connecting portion, being attached to or integral with the top portion, the connecting portion, and adjacent side portions, and contacting the vertical surface of the notch. The method may further include severing an electrical connection between the plurality of signal pads and the peripheral ring.

Although the invention(s) is/are described herein with reference to specific embodiments, various modifications and changes can be made without departing from the scope of the present invention(s), as set forth in the claims below. Accordingly, the specification and figures are to be regarded in an illustrative rather than a restrictive sense, and all such modifications are intended to be included within the scope of the present invention(s). Any benefits, advantages, or solutions to problems that are described herein with regard to specific embodiments are not intended to be construed as a critical, required, or essential feature or element of any or all the claims.

Unless stated otherwise, terms such as "first" and "second" are used to arbitrarily distinguish between the elements such terms describe. Thus, these terms are not necessarily intended to indicate temporal or other prioritization of such elements. Similarly, the description may refer to a "top" or "bottom" of a device or element without the intent of limiting the spatial orientation; accordingly, embodiments where the orientation is reversed are contemplated. It should be understood that such terms are utilized to provide a clear description of an implementation of the invention.

The term "coupled" is defined as connected, although not necessarily directly, and not necessarily mechanically. The terms "a" and "an" are defined as one or more unless stated otherwise. The terms "comprise" and any form of comprise, such as "comprises" and "comprising"), "have" (and any form of have, such as "has" and "having"), "include" (and any form of include, such as "includes" and "including") and "contain" (and any form of contain, such as "contains" and "containing") are open-ended linking verbs. As a result, a system, device, or apparatus that "comprises," "has," "includes" or "contains" one or more elements possesses those one or more elements but is not limited to possessing only those one or more elements. Similarly, a method or process that "comprises," "has," "includes" or "contains" one or more operations possesses those one or more operations but is not limited to possessing only those one or more operations.

## Claims

1. A method of manufacturing a semiconductor device, the method comprising:
providing a microelectronics package comprising:
a leadframe comprising a peripheral ring that defines a perimeter of the microelectronics package;
a plurality of ground leads attached to or integral with the leadframe, each of the plurality of ground leads including a ground pad that is exposed through a bottom of the microelectronics package;
a plurality of signal pads exposed through the bottom of the microelectronics package;
one or more microelectronic components each affixed to one or both of the leadframe and one or more of the plurality of signal pads; and
a layer of molding compound disposed over the leadframe, the plurality of ground leads, the plurality of signal pads, and the one or more microelectronic components;
making a first cut into the microelectronics package at the perimeter, the first cut extending from a top of the microelectronics package into the peripheral ring of the leadframe to expose one or more contact surfaces of the peripheral ring; and
forming a shielding enclosure that completely covers the top of the microelectronics package and a plurality of sides of the microelectronics package formed by the first cut, and that contacts the peripheral ring at the one or more contact surfaces, the shielding enclosure comprising an electromagnetic shielding material, and the shielding enclosure maintaining contact with the peripheral ring entirely around the microelectronics package.

2. The method of claim 1, wherein the layer of molding compound extends to the perimeter, and making the first cut comprises cutting vertically through the layer of molding compound to a first depth within the peripheral ring to form the plurality of sides including a vertical contact surface of the one more contact surfaces.

3. The method of claim 1 or 2, wherein making the first cut comprises forming a notch in the peripheral ring extending inward from the perimeter, the one or more contact surfaces comprising a vertical surface and a horizontal surface defined by the notch.

4. The method of claim 3, wherein forming the shielding enclosure comprises:
forming a top plate of the shielding enclosure on the top of the microelectronics package;
forming a plurality of side plates of the shielding enclosure each on a corresponding side of the of the plurality of sides, the plurality of side plates each being integral with the top plate and with adjacent side plates and each contacting the vertical surface of the notch; and
forming a connecting portion of the shielding enclosure on the horizontal surface of the notch, the connecting portion being integral with the plurality of side plates and extending around the perimeter.

5. The method of any preceding claim, wherein forming the shielding enclosure comprises depositing the electromagnetic shielding material onto the microelectronics package with a metal plating process.

6. The method of any preceding claim, wherein the plurality of signal pads are each electrically connected to the peripheral ring of the leadframe, the method further comprising severing the electrical connection between the peripheral ring and the plurality of signal pads.

7. The method of claim 6, wherein the microelectronics package further comprises a plurality of conductive connecting portions each connecting a corresponding signal pad of the plurality of signal pads to the peripheral ring of the leadframe, and wherein severing the electrical connection comprises making a second cut into the bottom of the microelectronics package and through the plurality of connecting portions.

8. The method of any preceding claim, wherein:
the microelectronics package further comprises a plurality of conductive connecting portions each:
attached to or integral with a corresponding one of the plurality of signal pads;
attached to the peripheral ring of the leadframe;
disposed approximate the bottom of the microelectronics package; and
having a thickness that is less than a thickness of the leadframe;
the plurality of ground leads each has the thickness of the leadframe; and
the method further comprises making a second cut into the bottom of the microelectronics package inward of the peripheral ring and through the plurality of connecting portions and the plurality of ground leads, the second cut having a depth at least equal to the thickness of the plurality of connecting portions and less than the thickness of the plurality of ground leads.

9. An electromagnetically shielded microelectronic semiconductor device comprising:
a microelectronics package comprising:
a leadframe comprising a peripheral ring that defines a perimeter of the semiconductor device;
a plurality of ground pads and a plurality of signal pads exposed through the bottom of the microelectronics package, the ground pads in electrical communication with the leadframe;
one or more microelectronic components each affixed to one or both of the leadframe and one or more of the plurality of signal pads; and
a layer of molding compound disposed over the leadframe, the plurality of ground pads, the plurality of signal pads, and the one or more microelectronic components, a top surface of the layer defining a top of the microelectronics package; and
a shielding enclosure that completely covers the top of the microelectronics package and a plurality of sides of the microelectronics package and that contacts the peripheral ring entirely around the microelectronics package along or within the perimeter, the shielding enclosure comprising an electromagnetic shielding material and cooperating with the leadframe to provide full-enclosure electromagnetic shielding to the one or more microelectronic components.

10. The semiconductor device of claim 9, wherein the peripheral ring comprises a horizontal contact surface extending inward along the perimeter, the shielding enclosure contacting the horizontal contact surface.

11. The semiconductor device of claim 10, wherein the peripheral ring comprises a notch including the horizontal contact surface and a vertical contact surface extending from a top of the peripheral ring downward to connect with the horizontal contact surface, the shielding enclosure further contacting the vertical contact surface.

12. The semiconductor device of claim 11, wherein the vertical contact surface of the peripheral ring and a vertical surface of the layer of molding compound together define the plurality of sides of the microelectronics package, the plurality of sides being disposed inward from the perimeter.

13. The semiconductor device according to any of claims 10 to 12, wherein the shielding enclosure comprises:
a top portion disposed on the top of the microelectronics package;
a connecting portion disposed on the horizontal contact surface; and
a plurality of side portions each disposed on a corresponding side of the plurality of sides and each attached to or integral with the top portion, the connecting portion, and adjacent side portions.

14. The semiconductor device according to any of claims 9 to 13, wherein the shielding enclosure comprises metal plating.

15. The semiconductor device according to any of claims 9 to 13, wherein:
the peripheral ring of the leadframe has a thickness measured from the bottom of the microelectronics package;
the microelectronics package further comprises a plurality of ground leads attached to or integral with the peripheral ring and having the thickness of the peripheral ring, each of the plurality of ground leads including a corresponding one of the plurality of ground pads; and
the semiconductor device further comprises a cavity disposed in the bottom of the microelectronics package adjacent to the peripheral ring, the cavity having a depth that is less than the thickness of the peripheral ring, the plurality of signal pads being electrically isolated from the peripheral ring by the cavity.
